(19) **Europäisches Patentamt / European Patent Office / Office européen des brevets**

(11) **EP 2 381 578 A1**

(12) **EUROPEAN PATENT APPLICATION**

(43) Date of publication:
**26.10.2011 Bulletin 2011/43**

(51) Int Cl.:
***H03M 3/04*** *(2006.01)*

(21) Application number: **10250817.3**

(22) Date of filing: **22.04.2010**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA ME RS**

(71) Applicant: **NXP B.V.**
**5656 AG Eindhoven (NL)**

(72) Inventors:
• **Breems, Lucien Johannes**
 **Redhill**
 **Surrey RH1 1DL (GB)**

• **Hu, Jingjing**
 **Redhill**
 **Surrey RH1 1DL (GB)**

(74) Representative: **Ashton, Gareth Mark et al**
 **NXP Semiconductors**
 **Intellectual Property and Licensing Department**
 **Betchworth House**
 **57-65 Station Road**
 **Redhill, Surrey RH1 1DL (GB)**

(54) **A sigma delta converter**

(57) A sigma delta converter (1100) comprising an adder (1104), a loop filter (1106), a quantizer (1108), a dynamic element matching component (1112), and a digital to analogue converter (1114). The adder (1104) is configured to add a converter input signal (1102) to an output signal from the digital to analogue converter (1114), the loop filter (1106) is configured to filter the output of the adder (1104), the quantizer (1108) is configured to process the output of the loop filter (1106), the output of the quantizer (1108) is configured as the output (1110) of the sigma delta converter and is also provided as an input to the dynamic element matching component (1112), and the output of the dynamic element matching component (1112) is provided as the input to the adder (1104). The sigma delta converter further comprises a dither signal generator (800) configured to generate a band limited dither signal (808; 1122), and the dither signal (808; 1122) is configured to be applied to a node in the sigma delta converter (1100).

Figure 11a

**Description**

The present disclosure relates to the field of sigma delta converters and dither signal generators, and particularly, although not exclusively, dither signal generators that are configured to insert frequency band-limited dither/noise into a sigma delta converter, or any multi-bit data converter.

Sigma delta analogue-to-digital converters (ADC's) and digital-to-analogue converters (DAC's), collectively referred as sigma delta data converters, are widely used in high-precision, low to medium bandwidth applications.

Multi-bit DAC's and ADC's have advantages over single bit designs, including a better selection of noise shaping functions and better suppression of quantization noise, although a drawback of multi-bit converters is a requirement for matching between elements in order to achieve linearity and low noise.

US 6,384,761 (Melanson) discloses a multi-bit data converter.

The listing or discussion of a prior-published document or any background in the specification should not necessarily be taken as an acknowledgment that the document or background is part of the state of the art or is common general knowledge.

According to a first aspect of the invention, there is provided a sigma delta converter comprising:

an adder;
a loop filter;
a quantizer;
a dynamic element matching component;
a digital to analogue converter;

wherein the adder is configured to add a converter input signal to an output signal from the digital to analogue converter, the loop filter is configured to filter the output of the adder, the quantizer is configured to process the output of the loop filter, the output of the quantizer is configured as the output of the sigma delta converter and is also provided as an input to the dynamic element matching component, and the output of the dynamic element matching component is provided as the input to the adder;

wherein the sigma delta converter further comprises a dither signal generator configured to provide a band limited dither signal;

wherein the band limited dither signal is configured to be applied to a signal/node in the sigma delta converter.

The band limited dither signal can be considered as a noise signal that has been limited in terms of one or more frequency bands. For example, the dither signal may have had one or more frequency bands removed, or may have been generated such that it does not have any significant components at some frequency bands.

The band limited dither signal can de-correlate linearities that may be introduced by a data weighting averaging algorithm that is implemented by the dynamic element matching component, and in some embodiments can also de-correlate the quantizer. The de-correlation of such linearities may be particularly noticeable for low input signal levels. This can improve the tonal performance/behaviour of the sigma-delta converter (that is, reduce the energy/amplitude of in-band tones due to correlation of the quantization error with the signal). It will be appreciated that the signal can be injected at any node in the sigma-delta converter.

The dither signal generator may comprise:

a signal generator configured to generate a dither signal; and
a filter configured to remove one or more frequency components of the dither signal and provide a filtered dither signal as the band limited dither signal.

In some examples, the dither signal generator may comprise a memory (optionally on a chip)_on which is stored data representative of the dither signal, such that the dither signal may be retrieved from the memory as required. In a further example, the dither signal generator may be external to the sigma delta converter such that the dither signal generator can be externally supplied.

It will be appreciated that the dither signal may be any signal that does not have a significant pattern such that it can be effectively used as a noise/dither signal.

In this way the dither signal generator can create a noise signal only at those frequencies that will not interfere with the performance of the converter.

The dither signal generator may comprise a pseudo random signal generator, and the dither signal may be a pseudo random signal. In other embodiments, the dither signal may be a random signal, or any other type of signal that is useful for dithering.

The one or more frequency components that are removed may correspond to in-band frequencies associated with a use/application of the converter. This can enable the band limited dither signal to only have frequency components that correspond to out-of-band frequencies.

In some embodiments, the band limited/filtered dither signal can be in a frequency band that does contain signal, but that is not required for use by an application. In case a signal is received that corresponds with the particular band that the band limited/filtered dither signal occupies, the band limited dither signal can be moved/applied in another signal band. This can mean that embodiments of the invention are not restricted to only out-of-band dither signals; but can also use filtered dither signals that are at frequencies inside the signal band of interest. In such examples, functionality should be provided for the frequency components of the filtered dither signal to 'hop' to a different frequency band that is not inside the band of interest.

The filter may comprise one or more of a band pass filter, a band stop filter, a high-pass filter or a low-pass filter, as non-limiting examples. It will be appreciated that any number of filters, of any type, can be used in order to achieve a desired frequency profile in accordance with the intended use/application of the converter/system with which the noise generator is to be used.

The filter may be a band pass filter with a pass band from about 1700kHz to about 2300kHz, or about 288kHz to 530kHz, for example. These frequency ranges correspond to out-of-band frequencies in amplitude modulated (AM) radio signals, and therefore ensures that frequency components of the dither signal that would correspond to in-band frequencies of the AM signals are removed by the filter.

It will be appreciated that the band limited dither/noise signal may have only frequency components in one or more frequency bands that do not contain useful information, and/or frequency bands that are not used. For example in a NZIF FM receiver, the FM band could be located from 1.2MHz to 21.7MHz. In such an example, the band limited noise signal can have components in the band from 0-1.2MHz and/or in a band higher than 21.7MHz.

The filter may be an adjustable filter that is configured to receive a control signal indicative of an in-use frequency band, and (automatically) adjust the frequency of the one or more frequency components that are removed in accordance with the control signal. The in-use frequency band may comprise frequencies that are being received by a radio that is associated with the converter/noise generator. For example the frequency of a specific radio station that a user is listening to.

In some embodiments, one or more frequency components of the band limited dither/noise signal can be located at frequencies inside the FM band, but at frequencies that are known to be not required by a user. In further embodiments still, the filter can be adjustable, optionally automatically adjustable, such that the frequency components that remain in the dither/noise signal after filtering do not correspond with frequency components that are being used by a user of a device associated with the converter/dither signal generator. For example, if a user is listening to Radio 1 at a frequency of 10MHz on a radio having a dither signal generator/converter according to an embodiment of the invention, then a controller may set one or more parameters of the adjustable filter in the noise generator in accordance with a control signal such that the frequency components that are removed by the filter correspond to at least the frequency components associated with Radio 1. Similarly, if a user is listening to Radio 2 at a frequency of 15MHz, then the dither signal generator can be automatically adjusted such that the frequency components that are removed correspond to at least the frequency components associated with Radio 2, and this may involve not necessarily removing frequency components associated with Radio 1.

Such embodiments may be put into practice by adjusting parameters of the filter in accordance with the tuning of a radio associated with the noise generator, and/or by using a controller.

In this way, an adaptive dither signal generator can be provided such that the frequency components of the noise signal can be changed to another frequency band in the FM band if it is desired to receive a particular channel at a frequency that had been previously used for dithering.

The dither/pseudo random signal may be a digital signal with n bits, and "n" may have a value of the order of 1, 2, or 3, or more bits as non-limiting examples. The most easy implementation can be achieved by using a dither/ pseudo random signal with n = 1. In some embodiments, the noise generator can comprise an n-bit pseudo random signal generator, wherein the n-bit pseudo random signal is fed to a 1-bit sigma-delta converter to create a 1-bit version of the n-bit pseudo random signal, and the 1-bit version is usable by the filter as the dither/pseudo random signal. In this way, only a 1-bit DAC is required to inject the pseudo random signal.

The dither signal generator (which may also be referred to as a noise generator) may further comprise a converter (such as a sigma-delta noise shaper) configured to convert the filtered dither/pseudo random signal into a converted filtered dither/pseudo random signal having fewer bits than the filtered dither/pseudo random signal. The converted filtered dither/pseudo random signal may be a digital signal with one bit, two bits or three bits, or any other number of bits that is sufficient to de-correlate a tonal spectrum of the converter with which the noise generator is associated.

In one embodiment, the sigma delta converter may further comprise a second adder located in the signal path between the loop filter and the quantizer. The second adder may be configured to add the output of the loop filter to the filtered dither/pseudo random signal in order to generate the input signal for the quantizer.

In another embodiment, the sigma delta converter may further comprise a second adder connected to the output of the quantizer. The second adder may be configured to add the output of the quantizer to the filtered dither/ pseudo random signal in order to generate the output signal of the sigma delta converter and the input signal for the dynamic element matching component.

In a further embodiment, the sigma-delta converter may further comprise a second digital to analogue converter configured to convert the filtered dither/pseudo random signal to an analogue filtered dither/pseudo random signal, and provide the analogue filtered dither/pseudo random signal to the adder for adding to the converter input signal and the output of the digital to analogue converter. Optionally, in order to compensate for the injected noise signal, the sigma delta converter may further comprise a second adder connected to the output of the quantizer, wherein the second adder is configured to add the filtered dither/pseudo random signal to the output of the quantizer in order to generate the output signal of the sigma delta converter. However, the output of the quantizer may be connected (possibly directly) to the input of the dynamic element matching component, such that the input signal to the dynamic element matching component is not received via the second adder. It will be appreciated that in some embodiments, the second adder to compensate for the injected noise signal may not be required because the noise signal only has components at frequencies that are not of interest. Therefore, the presence of the noise signal in the output signal of the converter can be considered as not significantly degrading the performance of the converter.

Such an embodiment has the advantage that the dynamic element matching component does not directly process any signals that include the injected noise signal, as the noise signal is not injected at a node directly before the dynamic element matching component. Therefore, the risk of correlating the noise signal and the error signal in the sigma-delta converter, and introducing linearities is reduced.

In a further still embodiment, the sigma delta converter may further comprise an optional second adder connected to the output of the quantizer, wherein the second adder is configured to add the filtered dither/pseudo random signal to the output of the quantizer in order to generate the output signal of the sigma delta converter. As with the previous embodiment, the output of the quantizer may be connected (possibly directly) to the input of the dynamic element matching component, and not via the second adder. The sigma-delta converter may further comprise a third adder located in the signal path between the dynamic element matching component and the digital to analogue converter, wherein the third adder is configured to add the filtered dither/pseudo random signal to the output of the dynamic element matching component, and provide the resultant signal as the input to the digital to analogue converter.

According to a further aspect of the invention, there is provided a dither signal/noise generator for a converter comprising:

> a dither signal generator configured to generate a dither signal; and
> a filter configured to remove one or more frequency components of the dither signal and provide a filtered dither signal as a band limited noise/dither signal.

The dither signal generator may be for a digital to analogue converter, an analogue to digital converter, a sigma-delta converter, or a multi-bit sigma delta converter, or any other type of converter. Embodiments of the dither signal generator may be particularly useful for converters, or any other system, that use a data weighted averaging (DWA) algorithm or any type of data element matching (DEM), as the noise/dither signal can be used to decorrelate any linearities in the system and/or improve the tonal performance of the system. The dither signal generator can also be used to improve the tonal behaviour/de-correlation of an ADC (quantizer) in the converter.

It will be appreciated that any of the optional features of a dither signal/noise generator that are disclosed in this document can be equally applicable to the dither signal generator according to this aspect of the invention.

There may be provided a converter comprising any dither signal generator disclosed herein, wherein the dither signal generator is configured to apply the band limited dither signal to any signal/node in the converter. The converter may be a digital to analogue converter, an analogue to digital converter, a sigma-delta converter, or a multi-bit sigma delta converter, or any other type of converter.

There may be provided a radio receiver comprising any dither signal generator and/or sigma delta converter described herein, wherein the one or more frequency components correspond to out-of-band frequencies in radio signals that are to be processed by the radio receiver. The radio signals may be amplitude modulation (AM) signals, or any other radio signals.

According to a further aspect of the invention, there is provided a method of generating a band limited dither signal for a converter, comprising:

> generating a dither signal;
> removing one or more frequency components of the dither signal in order to provide a filtered dither signal; and
> providing the filtered dither signal as the band limited dither signal.

There may also be provided a method of processing a received signal (such as an AM radio signal), the method comprising:

converting the received signal from the analogue domain to the digital domain using a sigma-delta converter; and injecting a noise signal into the sigma-delta converter, wherein the noise signal is a filtered/band-limited dither signal.

Embodiments of the invention can be considered as relating to the provision of a band-limited dither signal.

There may be provided a computer program, which when run on a computer, causes the computer to configure any apparatus, including a noise generator, a converter, circuit, system, or device disclosed herein or perform any method disclosed herein. The computer program may be a software implementation, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software may be an assembly program.

The computer program may be provided on a computer readable medium such as a disc or a memory device, or may be embodied as a transient signal. Such a transient signal may be a network download, including an internet download.

A description is now given, by way of example only, with reference to the accompanying drawings, in which:

Figure 1 illustrates a prior art sigma-delta analogue to digital converter (DAC);
Figure 2 illustrates further details of a digital DEM component and DAC;
Figure 3 illustrates schematically values that are attributed to elements for consecutive conversion cycles as generated by a digital encoder;
Figure 4 represents the simulated ideal output spectrum of a modulator;
Figure 5 illustrates two simulated output spectra;
Figure 6 illustrates schematically a first-order DEM algorithm for attributing values to elements in a -DEM component;
Figure 7 illustrates graphically the performance of prior art sigma-delta converters;
Figure 8 illustrates a noise generator according to an embodiment of the invention;
Figure 9 illustrates graphically the performance of a sigma-delta converter according to an embodiment of the invention;
Figure 10 illustrates graphically the performance of a sigma-delta converter according to an embodiment of the invention;
Figures 11 a to 11 d illustrate sigma-delta converters according to embodiments of the invention; and
Figures 12a to 12h illustrate graphically the performance of sigma-delta converters disclosed herein.

One or more embodiments disclosed herein can provide a band limited noise/dither signal for a converter such as a sigma-delta converter, whereby the dither signal is used to de-correlate linearities in the performance of the converter. Such linearities may be introduced by a data weighted averaging (DWA) algorithm that is performed by a dynamic element matching component of the sigma-delta converter, and the DWA algorithm may cause "tones" to appear in the frequency spectrum of the sigma-delta converter. Embodiments disclosed herein can improve the tonal performance of a sigma-delta converter by introducing a noise/dither signal into the sigma-delta converter, whereby the noise/dither signal is band-limited in terms of frequency such that any significant noise that is introduced into the sigma-delta converter occurs at out-of-band frequencies; that is frequencies that are not of interest for a specific application of the sigma-delta converter.

In this way, the requirements to cancel out any noise that is introduced into the sigma-delta converter (or any other system) is relaxed as the noise is only injected at frequency values that will not significantly degrade the performance of the sigma-delta converter.

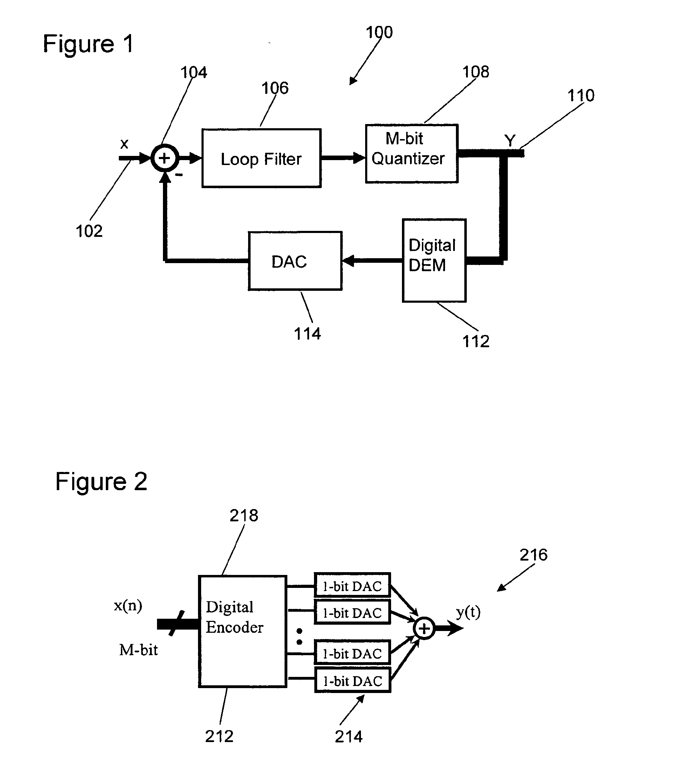

Dynamic element matching (DEM) is a technique which can be applied to oversampled multi-bit digital to analogue converters (DAC) that are known to be used as part of a sigma-delta analogue to digital converter. An example of a prior art sigma-delta analogue to digital converter (ADC) is shown as Figure 1.

The sigma-delta ADC 100 of Figure 1 receives an analogue signal x 102, which is provided as an input to an adder 104. The output of the adder 104 is provided to a loop filter 106, and the output of the loop filter 106 is provided to a M-bit quantizer 108. The output of the M-bit quantizer 108 is the digital output signal Y 110 of the converter, and is also fed back to a digital DEM component 112. The output of the digital DEM component 112 is provided to a digital to analogue converter (DAC) 114, the output of which is provided as a negative input to the adder 104.

As is known in the prior art, dynamic element matching (DEM) can improve the mismatch-induced non-linearity of the sigma-delta ADC 100, and this can be achieved by randomising the mismatch errors by applying a noise shape function.

Figure 2 illustrates further details of the digital DEM component 212 and DAC 214. In this example, the DAC 214 consists of a plurality of one bit DAC's, which can be independently operated such that the summation of the outputs of the one-bit DAC's 214 is provided as signal y(t) 216, which represents the analogue equivalent of the received digital signal 218. Each of the one-bit DAC's 214 may be referred to as an element.

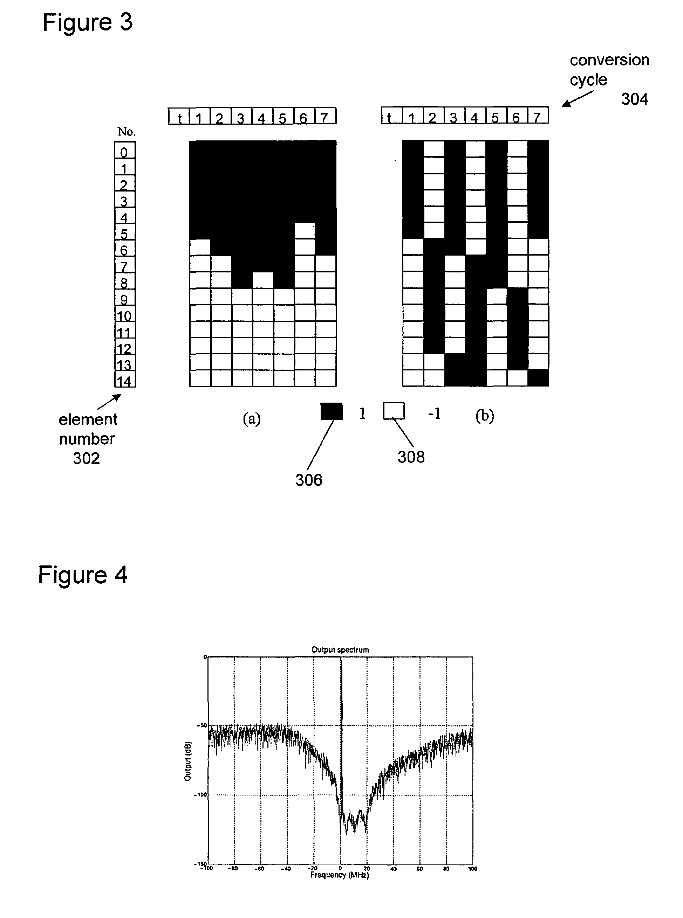

Figure 3 illustrates schematically values that are attributed to elements for consecutive conversion cycles as generated by a digital encoder.

In the example of Figure 3, a four bit DAC is illustrated, thereby comprising fifteen independent elements as identified with reference 302 in Figure 3. Figure 3 shows the element values for seven consecutive conversion cycles, the index of which is shown with reference 304 in Figure 3.

Each of the elements can have a value of either + 1, which is shown as a solid block 306 in Figure 3, or a value of - 1 as shown with an open block 308 in Figure 3.

The example of Figure 3a is illustrative of a four bit DAC without DEM, and Figure 3b is illustrative of a four bit DAC with first order DEM.

The relationship between the output code value and the number of +1 elements is shown in Table 1.

| Output code | -15 | -13 | -11 | -9 | -7 | -5 | -3 | -1 | 1 | 3 | 5 | 7 | 9 | 11 | 13 | 15 |
|---|---|---|---|---|---|---|---|---|---|---|---|---|---|---|---|---|
| Number of +1 elements | 0 | 1 | 2 | 3 | 4 | 5 | 6 | 7 | 8 | 9 | 10 | 11 | 12 | 13 | 14 | 15 |
| Number of -1 elements | 15 | 14 | 13 | 12 | 11 | 10 | 9 | 8 | 7 | 6 | 5 | 4 | 3 | 2 | 1 | 0 |

For a sequence of DAC feedback output values of - 3, - 1, 3, 1, 3, - 5, - 1, for seven consecutive conversion cycles it can be seen from Table 1 that a sequence of 6, 7, 9, 8, 9, 5, 7 elements should be selected with a value "+1 for conversion cycles from t=1 to t=7. The remainder of the elements should be selected with a value of "-1". Such a sequence of selected elements is shown as Figure 3a.

A first-order dynamic element matching algorithm can be considered as a rotation of the selection of the elements with a "+1" value, such that an element is selected as "+1" for a subsequent conversion cycle starting from the next element to be selected from the previous conversion cycle. Such a first-order DEM algorithm is shown as Figure 3b.

'Dynamic element matching techniques with arbitrary noise shaping function', by O. Nys and R.K. Henderson, International symposium on circuit and system, pp.293-296, May. 1996 shows that, in theory, a higher-order noise shaping algorithm can be used to achieve better linearity. However, a noise shaping function higher than first-order is rarely used in practice due to the complexity of the implementation. For example, the increase in complexity can mean that the required processing cannot be performed quickly enough. The mass computation of scrambling a digital code can make known higher order dynamic element matching algorithms impossible to be implemented at a high sampling rate.

Prior art digital methods of implementing a higher order DEM algorithm can require a swap matrix which has a complexity proportional to $2^N$ (N bit quantizer). Such a matrix calculation can cause considerable delay which can influence the stability of the system. Other prior art methods include a sorting algorithm, which can sort a quantizer output with a second order digital sigma delta converter. Both of these examples of the prior art can have a limitation in terms of a calculation time, such that they are not suitable for use in a high speed multi-bit sigma-delta modulator. It can be very difficult, if not impossible, to implement the sorting for a four-bit quantizer above 100 MHz clock frequency.

For the following description, a model of a continuous-time complex fourth order four-bit sigma-delta modulator is used for simulations. The loop filter has four complex notches in the frequency band from 0 to 20 MHz. The sampling frequency is 436.8 MHz. The frequency spectrum shown in Figure 4 represents the simulated ideal output spectrum of such a modulator, and can be used as a reference frequency spectrum for the embodiments of the invention that follow. The noise is suppressed by four complex resonators at different frequencies in the signal band, and this causes four notches to be seen in the band. Any DAC mismatch induced noise can fill the notches, and therefore increase the noise floor, which can cause degradation in the performance of the sigma-delta modulator.

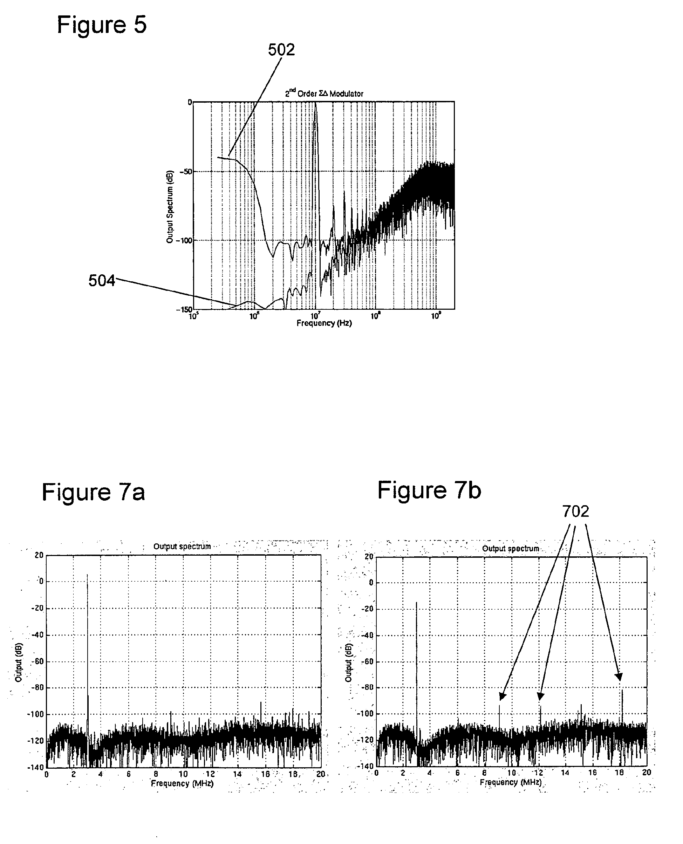

Figure 5 illustrates two simulated output spectra for a typical second order sigma-delta modulator with a four-bit DAC. The curve shown with reference 502 represents the output spectrum for unit elements of the four-bit DAC with a 1% (one sigma) mismatch. The curve with reference 504 represents the same modulator having a four-bit DAC with dynamic element matching. It can be seen from Figure 5 that the mismatch induced non-linearity of the converter with DEM is now first-order shaped, and the strong nonlinear tones have been reduced. As discussed above, the first-order DEM algorithm uses all of the DAC elements at a maximum possible rate, while ensuring that each element is used an equal number of times on average to reduce the mismatch influence and shape the non-linearity. Control algorithms for attributing values to each of the elements in the DAC are described below.

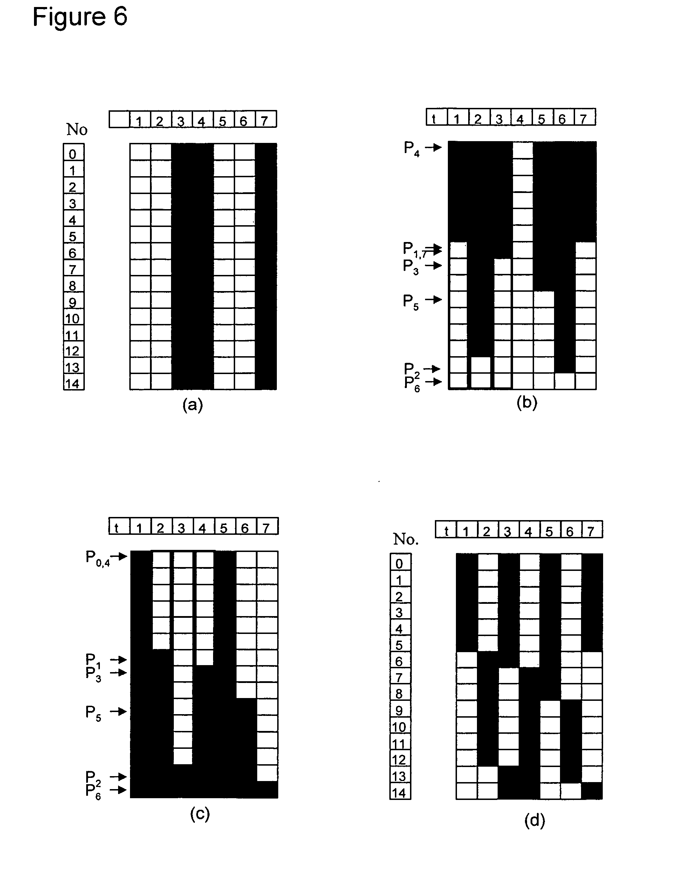

As a first example, a first-order DEM algorithm will be described with reference to Figure 6. As mentioned above in relation to the first order DEM, a pointer rotation scheme, is used such that the new pointer for a present conversion cycle is the previous pointer value for the previous conversion cycle plus the number of "+1" elements that have been used as part of the previous conversion cycle. For the present conversion cycle, the "+1" element selection can then start from the new pointer position. In case of an overflow, the element selection starts from the first element again. The resultant element selection is shown as Figure 3(b), which is the same as the element selection illustrated in Figure 6(d).

Figures 6(a) to (d) will now be described in relation to the implementation of the selection of the number of elements illustrated in the following table to provide an understanding of how elemental values can be attributed:

| Previous | Number of selected element index | New |
|---|---|---|
| $P_0=0$ | 6 | $P_1=6$ |
| $P_1=6$ | 7 | $P_2=13$ |
| $P_2=13$ | 9 | $P_3=22(7)$ |
| $P_3=7$ | 8 | $P_4=15(0)$ |
| $P_4=0$ | 9 | $P_5=9$ |
| $P_5=9$ | 5 | $P_6=14$ |
| $P_6=14$ | 7 | $P_7=21(6)$ |

It can be seen from the above table, that, for successive conversion cycles, the following sequence of DAC elements should be selected: 6, 7, 9, 8, 9, 5, 7.

The algorithm starts at step 1, whereby the new pointer value for the present conversion cycle is calculated. In this first order example, the new pointer value for the present conversion cycle is set as the pointer value for the previous conversion cycle ($P_{i-1}$) plus the number of elements that are to be selected for that conversion cycle ($Index_i$). That is:

$$P_i=P_{i-1}+Index_i$$

The new pointer value for the present conversion cycle is then compared with the total number of elements to determine if an overflow will occur. If it is determined that an overflow will occur, then all of the elements for the present conversion cycle are set as "+1", and if it is determined that an overflow will not occur, then all of the elements are selected as "-1". That is:

If $0=<P_i<15$, then all elements are selected as "-1";
If $P_i>=15$, then all elements are selected as "+1 ".

This initial selection of values may be considered as attributing first "component-values" for the elements, and is shown in Figure 6(a).

As a final stage in the first step of the algorithm, the new pointer value for the present conversion cycle is updated by a modulo operation to get the remainder for the next step in the algorithm. That is, the "overflow" part of the pointer value is removed:

$$P_i=mod\ (P_i,\ 15)$$

The first step in the algorithm may be considered as pre-compensation.

As a second step in the algorithm, the elements with a number/index from 0 to the new pointer value ($P_i$) are selected as "+1 ", and the elements from $P_i$ to 14 are selected as "-1". This may be considered as attributing a second component-value to each of the elements. This is shown as Figure 6(b).

As a third step in the algorithm, the elements with a number/index from 0 to the pointer position in the previous

conversion cycle ($P_{i-1}$) are selected as "-1", and the elements from $P_{i-1}$ to 14 are selected as +1. This can be considered as attributing a third component-value to the elements which is the same as the inverse of the second component-value for the previous conversion cycle. Such a selection of elements is shown as Figure 6(c).

Finally, as a fourth step in the algorithm, the three component-values for each of the elements that were calculated in the first three steps of the algorithm (as shown in Figures 6(a) to (c)) are added together in order to obtain the final values that are to be attributed to/selected for each of the elements for the present conversion cycle. The result of the summation of the first three component values is shown as Figure 6(d).

The algorithm that is described with reference to Figure 6 can provide an efficient algorithm in terms of processing operations for calculating a DEM/DWA algorithm for attributing values to elements of a converter. The algorithm can also be readily extended to higher order algorithms without significantly increasing the processing requirements.

The DEM/DWA can be understood as time domain compensation. For example, the selection scheme in step 3 has exactly the opposite sequence of values for step 2 of the previous conversion cycle. This means that elements which are selected as +1 in the third step of the algorithm, will be selected as -1 in the second step of the algorithm for the next conversion cycle, and vice versa. That is to say, all of the elements are selected as an opposite value once every two clock cycles. This can lead to any mismatching between the fifteen elements being cancelled, or at least reduced, when averaged over time.

The rotation scheme of the first-order DWA algorithm can be considered to work quite well for large input signals. However, when the input signal is small, the amount of +1's and -1's are more or less half of the total thermal meter code. Considering the rotation scheme of the 1$^{st}$ order DWA, this can mean that the group of +1 elements and the group of -1 elements are quickly swapped. For particularly small input signals, only one element may be selected with a "+1" value for a number of consecutive cycles. Such code combinations can be considered as limited due to the small signal, and as a result, the swapping of element values can repeat with the same pattern regularly/often, thereby introducing low frequency artifacts.

Figure 7 illustrates a comparison between frequency a simulated response of a first-order DWA algorithm used in a sigma-delta modulator for large and small input signals. Both simulations were performed with a 10% mismatch between elements. Figure 7a illustrates a simulated output spectrum of a sigma-delta modulator with full-scale (large) input signals. Figure 7b illustrates a simulated output spectrum of a sigma-delta modulator with (small) 10% full-scale (-20dBFS) input signals. Higher frequency tones 702 can be seen in the spectrum for the DWA algorithm that receives small input signals, which are not present in the spectrum for the DWA algorithm that receives large input signals.

Therefore, first-order DWA can be considered as being sub-optimal for small input signals, due to the generation of low-frequency tones that can occur at frequencies of interest (which may be referred to as in-band frequencies). In such situations the first-order DWA may not be efficient enough to spread out the mismatch induced nonlinearity and "move" it to high frequencies that are not in-band frequencies. This is a limitation of the first-order DWA algorithm. Second-order DWA is known to suffer much less from this tonality problem, however second-order can be very difficult and costly to implement. In some examples, a second-order DWA may not even be able to operate quickly enough to satisfy timing requirements.

In principal, any type of dither/noise signal can be applied to a sigma-delta converter to achieve a de-correlation effect and improve the tonal behaviour of the sigma-delta converter. However, it has been found that adding a "white noise" dither signal can result in an increased noise level in the desired signal band due to the limited gain of the loop filter. Also, it may not be possible to perfectly cancel out a dither noise signal due to imperfections in the analogue components, thereby degrading the noise performance of the sigma-delta converter.

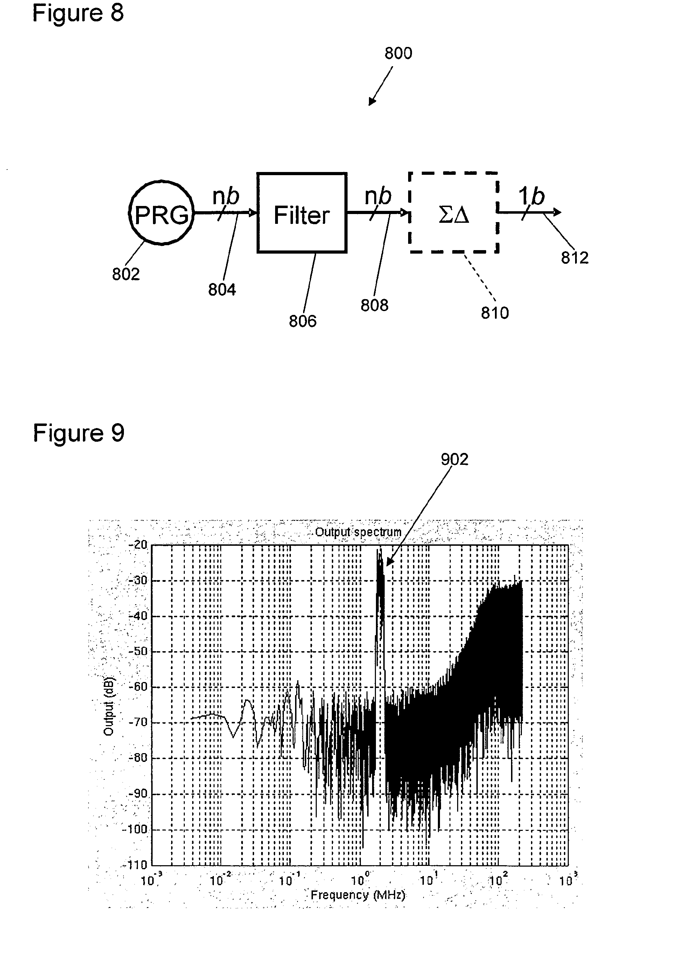

Figure 8 illustrates a band limited dither/noise generator 800 according to an embodiment of the invention. The noise generator 800 is configured to provide a band limited dither/noise signal for a multi-bit sigma-delta converter. In other embodiments the noise generator 800 can be configured to be used with any other type of converter including a digital to analogue converter (DAC), and analogue to digital converter (ADC).

The noise generator 800 comprises a signal generator, which in this embodiment is a pseudo random generator 802 that generates an n-bit pseudo random signal 804. It will be appreciated that in other examples, different types of dither signals can be generated by the signal generator 802 and that a pseudo random signal is a non-limiting example of a dither signal. The pseudo random signal 804 is provided to a filter 806 that can remove one or more frequency components of the pseudo random signal 804, in order to provide a filtered pseudo random signal 808. In this example, the filter 806 is a band-pass filter, although in other embodiments, band-stop, high-pass or low-pass filters can also be used.

The filter 806 is used to remove one or more frequency components of the pseudo random signal 804 such that the remaining frequency components of the filtered pseudo random signal 808 are at frequencies that are not of interest (out-of-band). It will be appreciated that the frequencies that are of interest relate to a specific application for the converter with which the noise generator 800 will be used, such as for a radio receiver. In one example, the filter 806 may be configured to filter out all frequency components except those in the range of about 1,700 to 2,300 kHz, which is a known "out-of-band" range of frequencies for amplitude modulation (AM) radio frequencies. In this way, the filtered pseudo random signal 808 can be used to inject noise into a sigma-delta converter in order to de-correlate the tonal spectrum of the sigma-delta converter, whilst restricting the degradation in the noise performance of the sigma-delta converter to frequencies that are not of interest (out-of-band). That is, the noise level in the frequency response of the sigma-delta converter can be increased at those frequencies that the filter 806 allows to pass, although this may not matter because such frequencies do not correspond with frequencies of interest that are to be processed by the sigma-delta converter.

In further embodiments still, the signal generator 802 may provide a dither signal that is already band limited in terms of frequency, and therefore filtering is not required.

An embodiment of the invention can be considered as implementing the idea that, after filtering, the dither noise only appears in one or more frequency bands that are not used by the application. For example, in the AM spectrum, there are a few frequency bands without AM signals which are: 0 to 144 kHz, 288 to 530 kHz and 1,710 to 2,300 kHz.

The pseudo random signal 804 may be considered as a pseudo white-noise signal. The filter 806 may be a filter that has a "sharp" frequency response, such as a sharp band-pass filter, so as to reduce the likelihood that noise is introduced into frequency bands of interest.

In some examples, the filtered pseudo random signal 808 can be injected directly into a sigma-delta converter. In other embodiments, a one-bit digital sigma-delta noise-shaper 810 can be used to convert the filtered pseudo random signal 808 into a one-bit code 812. This can provide a convenient implementation for injecting the noise signal into a sigma-delta converter, for example, as a relatively simple single bit DAC is required. In further embodiments still, a code/signal having any other number of bits can be used depending upon the application of the noise generator 800, and the means for injecting the noise signal can be adapted accordingly.

The dither signal power should be strong enough to de-correlate any correlation that may be induced by first order data waited averaging (DWA), especially in examples that receive a small input signal. In some embodiments, the characteristics of the injected dither may be selected so as to satisfy a balance between retaining a good noise performance (for example signal to noise ratio) and good tonal performance (for example a spurious free dynamic range). The power of the dithered noise signal should be strong enough to de-correlate the tonal behaviour due to the first order DWA, however, not too strong to undermine the in-band noise floor.

In some embodiments, the one-bit dither noise stream 812 can be generated "off-chip", that is by a different device/integrated circuit to that of the sigma-delta converter, and the one-bit dither noise stream 812 can be stored in a memory on the sigma-delta converter integrated circuit. Such an embodiment can provide advantages as the demands (which can be significant) of the filter 806 in terms of bandwidth and out-off-band suppression can be removed form the sigma-delta converter integrated circuit, which in turn can lead to a less costly implementation of the noise generator of Figure 8. Storing a one-bit dither noise stream 812 in memory can provide a more cost effective solution.

Simulations have shown that a dither stream of about 24kbit (3kB) can be sufficient to effectively de-correlate the tonality for a first-order DWA algorithm.

Figure 9 illustrates graphically the frequency spectrum of an output signal from a sigma-delta converter according to an embodiment of the invention. Figure 9 shows a band-limited, noise-shaped dither signal with a high amplitude in the 1,700 kHz to 2,300 kHz band and is shown with reference 902 in Figure 9. This corresponds to the band-pass filter frequency range of the filter 806 shown in Figure 8.

Figure 9 also shows that the output level of the spectrum begins to increase significantly at frequencies in excess of 30 MHz, and this is due to the quantisation of the sigma-delta converter 810. In this example, frequencies in excess of 30 MHz are not signals of interest, and therefore the improved noise performance in the frequency ranges from 0 to 1,700 kHz, and 2,300 kHz to 27 MHz improves the performance of a sigma-delta converter that is used with AM radio signals.

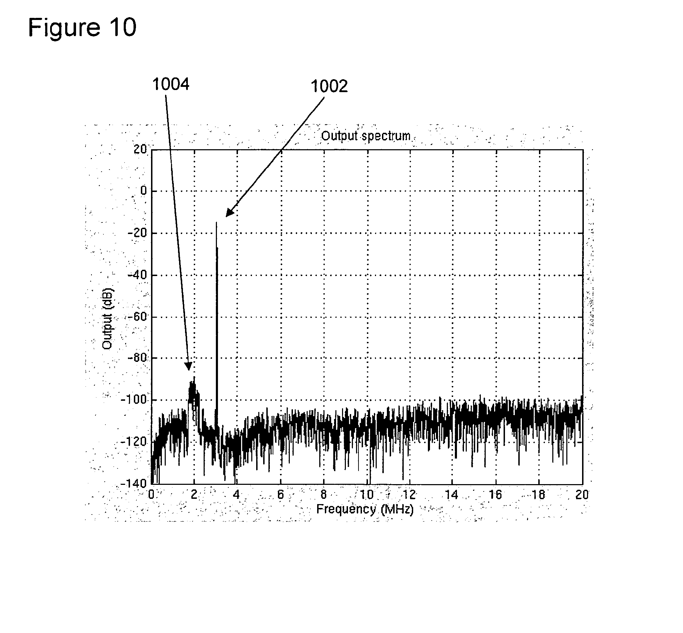

Figure 10 shows the spectrum of an output signal in the frequency range 0 to 20 MHz. The spectrum shows a small input tone 1002 at about 3MHz, and a dither signal band 1004 at frequencies of 1700kHz to 2300kHz.

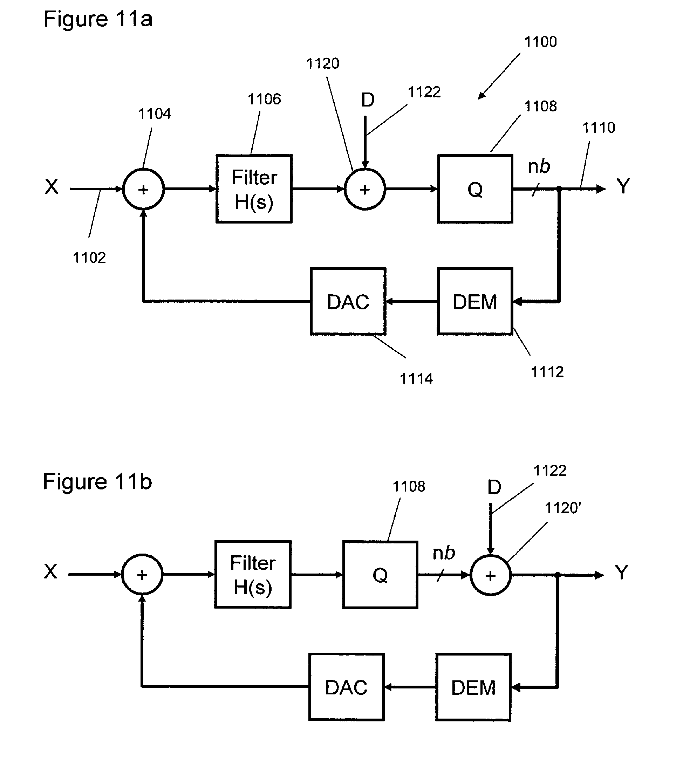

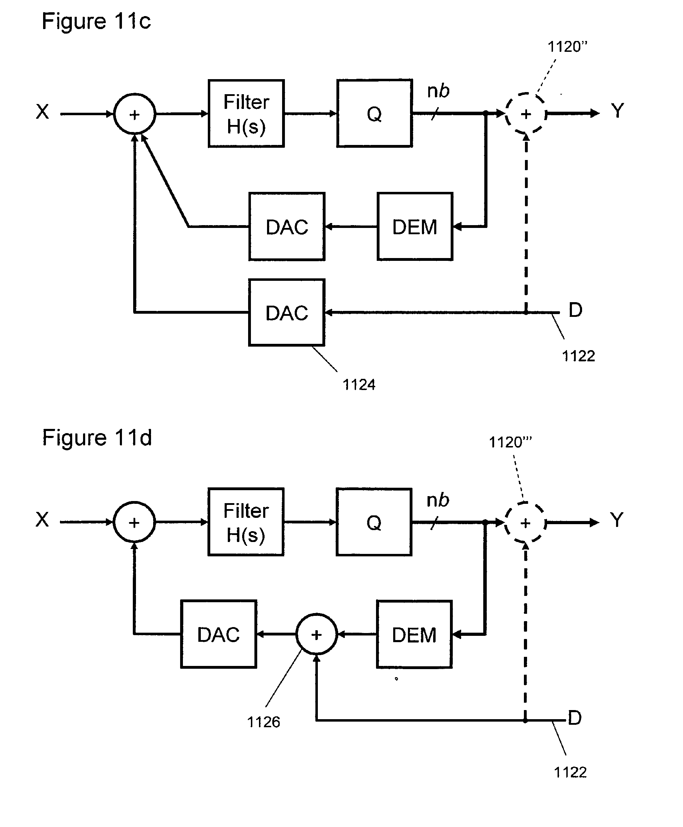

Some residual dither can be observed in Figure 10, although no tonal behavior due to the de-correlation effect of band-limited dither is visible. Figure 10 shows the simulated output spectrum with a small input tone (at -20dBFS, which is 10% of the full-scale input signal) at 3MHz. The dither of Figure 10 has been applied according to the scheme of Figure 11 b as described in more detail below. No harmonic tones can be observed in the 20MHz band due to the first-order DWA algorithm. It can be seen (from Figure 9) that the noise rises slightly for higher frequencies due to the first-order noise-shaping DWA algorithm. Although dithering of the first-order DWA can add some noise to the in-band spectrum in some examples, the tonal behavior is completely de-correlated to a level below -100dBFS.

In the band from 1700kHz to 2300kHz some residual dither can be observed due to the imperfect cancellation as a result of the mismatch in the multi-bit DAC of the sigma-delta A/D converter. However, for AM applications at least, this particular band does not contain signals, and therefore the residual dither does not introduce any performance degradation.

To appreciate the effectiveness of injecting the frequency filtered dither signal, the same small input signals that were applied to the simulation of Figure 7b, were injected into a converter along with frequency limited/filtered dither signal, and the results of such a simulation are shown in Figure 10. Both simulations use a first-order DWA algorithm. A comparison between Figure 7b and Figure 10 shows that the strong tones 702 of Figure 7b have been removed by injecting the frequency filtered dither signal. Also, the noise-floor of Figure 7b is slightly lower than that of Figure 10, and this is due to the fact that the applied frequency filtered dither signal transforms the tonal behavior of the first-order DWA.

Figures 11 a to 11 d illustrate sigma-delta converters according to embodiments of the invention, whereby band a limited dither signal D (which may also be known as frequency filtered noise) is injected into the sigma-delta converter to improve the tonal performance of the sigma-delta converter. Such improvements may be particularly noticeable for low input signals. As can be seen from Figures 11 a to 11 d, the band limited dither signal D can be injected at any node in the sigma delta converter.

In this example, the band limited dither signal D is provided by a dither signal generator such as the one illustrated in Figure 8. In other examples, the band limited dither signal D can be stored in a memory on a chip and retrieved from memory on demand, or otherwise externally supplied in any known way.

Each of the sigma-delta converters of Figures 11 a to 11 d include at least a loop filter 1106, a quantizer 1108, a dynamic element matching (DEM) component 1112 and a digital-to-analogue converter (DAC) as is known in the art. A prior art sigma-delta converter is described above with reference to Figure 1.

The sigma-delta converter 1100 of Figure 11 a includes an additional adder 1120 in the signal path between the output of the loop filter 1106 and the input of the quantizer 1108. In this way, a frequency filtered dither signal D 1122, which is an example of a filtered pseudo random signal, can be mixed with a signal in the sigma-delta loop in order to improve the performance of the sigma-delta converter.

In an alternative embodiment, the frequency filtered dither signal D 1122 can be injected/applied to an adder 1120' at the output of the quantizer 1108, as shown in Figure 11 b. The sigma-delta converter of Figure 11b operates in a similar way to the sigma-delta converter of Figure 11 a.

As indicated above, dither can be considered as an error signal that is deliberately injected into the system. Therefore the frequency filtered dither signal D 1122 can degrade the resolution of the sigma-delta converter into which it is injected. When the frequency filtered dither signal D 1122 is injected at the input of the quantizer 1108 (as shown in Figure 11 a), the effect of the frequency filtered dither signal D 1122 is reduced by approximately the gain of the loop filter 1106 (H). Since this loop filter 1106 gain is usually high, the effect of dither can be generally mitigated/reduced.

In order to change the output code of the quantizer 1108, the dither amplitude can be of the order of 1 LSB (Least Significant Bit) of the quantizer level in some embodiments. However, the codes that are being output from the quantizer 1108, and that have been randomized by the frequency filtered dither signal D 1122, are passed to the dynamic element matching component 1122 to apply a first-order DWA algorithm. This can correlate the dither signal and the error signal again and undermine the improvements in tonal behaviour achieved by the injected dither.

It has been found that in order to effectively de-correlate the dither signal and error signal for sigma-delta converters such as that of Figures 11a and 11b, a dither signal level of the order of 3LSB should be applied. However, a problem with injecting a dither signal with such a high level is that the in-band noise floor is further increased, therefore detracting from the noise performance of the sigma-delta converter.

In order to address any problems associated with the DEM component 1112 re-correlating the dither signal, one or more embodiments of the invention can be configured such that the frequency filtered dither signal effectively bypasses the DEM component 1112. Two such embodiments are illustrated as Figures 11c and 11d.

The structure of the sigma-delta converter of Figure 11c is modified by injecting the frequency filtered dither signal D 1122 to the original adder 1104 of the sigma-delta converter. In this embodiment, the original adder 1104 is configured to process analogue signals and the frequency filtered dither signal is a digital signal. Therefore, the sigma-delta converter also includes a further DAC 1124, referred to herein as a dither DAC 1124, that converts the digital frequency filtered dither signal into an analogue signal for injecting to the original adder 1104.

In order to compensate for the frequency filtered dither signal D 1120 that is injected at the original adder 1104, the sigma-delta converter of Figure 11c includes an optional additional second adder 1120" that is connected in the signal path between the output of the quantizer 1108 and the output 1110, but not in the signal path between the output of the quantizer 1108 and the input of the DEM component 1112. That is, the additional adder 1120" is connected to the output of the quantizer 1108 after the signal path has split off to provide feedback via the DEM component 1112. The additional adder 1120" is used to inject the same frequency filtered dither signal D 1122 at the output of the sigma-delta converter as is injected at the input of the signal delta-converter. In some examples, it may not be necessary to compensate for the injected noise as the presence of noise at frequencies that are not of interest may be considered acceptable. In such examples, the optional additional adder 1120" may not be required.

For both the sigma-delta converters of Figures 11a and 11c, the dither signal D 1122 is suppressed by the gain H of the loop filter 1106. However, for the structure of Figure 11c, a dither signal with a level corresponding to 1 LSB level is sufficient to effectively de-correlate the tonal spectrum introduced by the DEM component 1112. In addition, a smaller amount of in-band noise is introduced by the system of Figure 11c in comparison with the system of Figure 11c.

Figure 11 d shows an alternative implementation of a sigma-delta converter according to an embodiment of the invention. In the same way as in Figure 11c, the frequency filtered dither signal D 1122 is injected at an optional additional adder 1120'" at the output of the sigma-delta converter.

In contrast to Figure 11c, the sigma-delta converter of Figure 11d includes a further additional third adder 1126 in the signal path between the output of the DEM component 1112 and the input to the feedback DAC 1114. In this way, the further additional adder 1126 can be used to introduce the frequency filtered dither signal into the feedback loop of the sigma-delta converter but bypassing the feedback DAC 1114.

An advantage of the sigma-delta converter of Figure 11d over the sigma-delta converter of Figure 11c is that an additional DAC is not required.

As above, the further additional adder 1126 is configured to couple/add the frequency filtered dither signal into a signal path in the sigma-delta converter.

It will be appreciated that the additional adder 1120'" in Figure 11d is used to compensate for (subtract) the dither signal that is injected into the system by the further additional adder 1126.

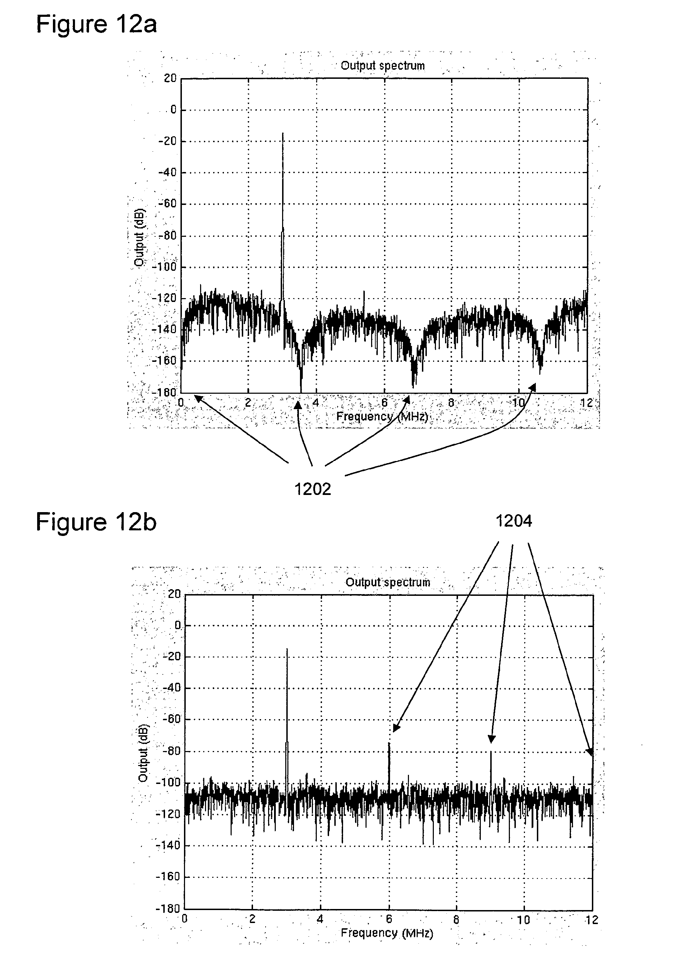

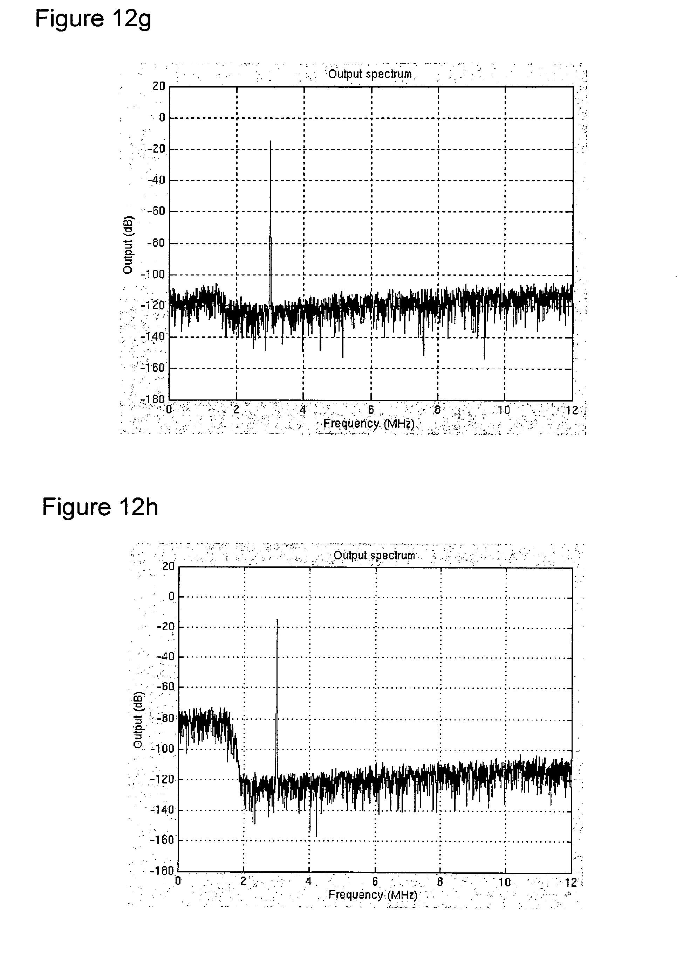

Figures 12a to 12h illustrate graphically the spectral performance of sigma-delta converters of the prior art and also of embodiments of the invention, as disclosed herein.

Figure 12a shows the simulated output spectrum of an ideal (that is with no mismatch between the multi-bit feedback D/A converters) fourth-order complex sigma-delta modulator with 4-bit quantizers and 4-bit feedback D/A converters. The maximum achievable simulated signal-to-quantisation noise ratio (SQNR) for an input signal of - 20dBFS is 84.7dB in a 10MHz band from 2MHz to 12MHz. The spurious free dynamic range (SFDR) is better than 100dB. The spectrum includes four notches 1202. This spectrum shown in Figure 12a is the reference for the simulations that follow as Figures 12b to 12h.

Figure 12b shows the simulated output spectrum of the same sigma-delta modulator as Figure 12a, but this time with a 1 % mismatch between the reference sources of the multi-bit feedback D/A converters. The mismatch degrades the SQNR to only 61.2dB as well as the SFDR to 60dB. It can be seen from Figure 12b that a number of tones 1202 have been introduced to the spectrum at frequencies of about 6 MHz, 9MHz and 12MHz. Also, the four notches 1202 that were present in the ideal spectrum of Figure 12a have gone.

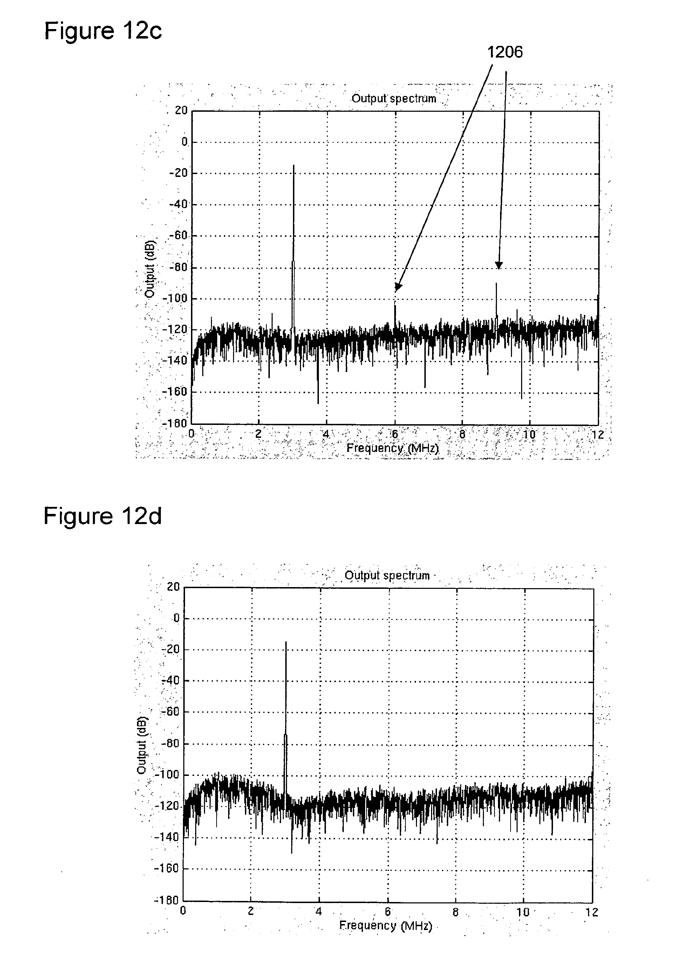

Figure 12c shows the simulated output spectrum when first-order DWA is applied to the 4-bit DACs with 1% mismatch of Figure 12b. It can be seen that the SQNR improves to 74.3dB. However the DWA itself causes tones 1206 in the band and limits the SFDR for this particular simulation to only 74.5dB.

Figure 12d shows the simulated output spectrum when random dither is injected into the sigma-delta converter of Figure 11a. The random dither that is injected into the converter of Figure 11a can be considered as "non-subtractive" dither as it is not compensated for by subtracting a similar dither signal from another position on the sigma-delta converter as in Figures 11c and 11 d. It can be seen from Figure 12d that the SFDR clearly improves at the cost of some degradation of the SQNR to 66.7dB.

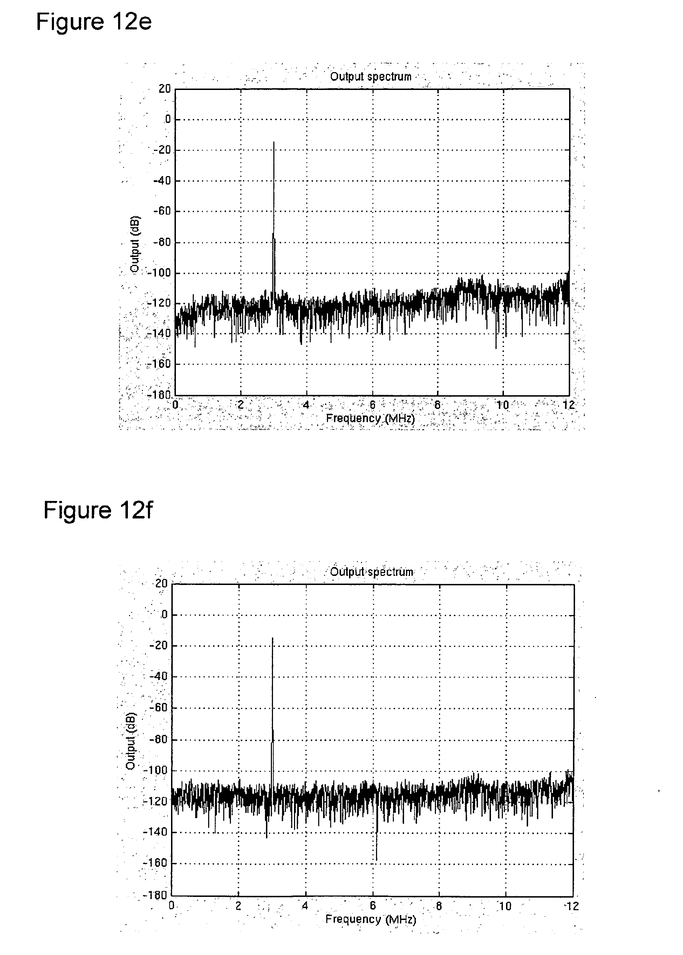

Figure 12e shows the simulated output spectrum when random dither is injected into the sigma-delta converter of Figure 11 c. The random dither that is injected into the converter of Figure 11c can be considered as "subtractive" dither. It can be seen that the SQNR improves to 69dB while the SFDR is still comparable with that of Figure 12d. However, when comparing the spectrum of Figure 12e with that of Figure 12a, it can be seen that the level of noise is particularly bad at high frequencies.

Figure 12f shows the simulated output spectrum with a 1% mismatch between the analogue and digital dither signals that is introduced by the additional DAC 1124 of Figure 11 c. Figure 12f demonstrates the sensitivity of the scheme of Figure 11c to mismatch between the analog and digital dither injection. A mismatch of only 1% between the analog and digital dither signals degrades the SQNR from 69dB to 67dB. Calibration may be required to achieve better than 1% matching, which provides further cost and complexity to the sigma-delta converter.

Figure 12g shows the simulated output spectrum wherein the dither that is injected is band-limited to frequencies below 2MHz by a noise generator such as that illustrated in Figure 8. The sigma-delta converter of Figure 11c is used to provide the simulation of Figure 12g. It can be seen from Figure 12g that the SNR is now improved to 70dB, and is only now limited to the noise introduced by the first -order DWA algorithm. The SFDR is also very good, and there are no significant tones present.

It can also be seen from Figure 12g that there is a reasonable amount of noise at frequencies below 2MHz due to the frequency filtered dither that has been injected. However, in this embodiment, frequencies below 2MHz are considered as out-of band and therefore are not considered to reduce the performance of the sigma-delta converter.

Figure 12g shows the simulated output spectrum of Figure 12g where the mismatch between the analog and digital dither has been increased to 5%. It can be seen that there is no significant performance degradation in the band from 2MHz to 20MHz, as the dither is only located in the band from 0-2MHz. Furthermore, no calibration is required for this dither scheme which can achieve better results than the prior art.

Shown below is a table summarising the results of the simulations shown in Figures 12a to 12g:

| Simulation | Figure | SNR (dB) | SNR (dB) |
|---|---|---|---|
| Ideal | 12a | 84.7 | 101.9 |
| Mismatch | 12b | 61.2 | 59.8 |
| Mismatch/DWA | 12c | 74.3 | 74.5 |
| Mismatch/DWA/rand dither | 12d | 66.7 | 82.8 |
| Mismatch/DWA/rand subtractive dither | 12e | 68.9 | 80 |
| Mismatch/DWA/rand subtractive dither/1% mismatch | 12f | 66.6 | 80 |
| Mismatch/DWA/filtered subtractive dither | 12g | 70.0 | 86 |
| Mismatch/DWA/filtered sub dither/1% mismatch | - | 70.0 | 87 |
| Mismatch/DWA/filtered sub dither/5% mismatch | 12h | 70.0 | 84 |
| SNR calculated in band from 2MHz-12MHz, Fin=3MHz, amplitude = -20dBFS | | | |

One or more embodiments described herein can relate to the use of dither in a multi-bit sigma-delta converter to reduce the tonal behavior of the DWA algorithm. The use of band limited dither may not add significant in-band noise.

The band-limited dither can be positioned at any non-used free bands in a frequency spectrum for a specific application of a converter.

The band-limited dither may be placed in low-frequency bands for maximum/improved effectiveness.

In some embodiments, either analogue or digital dither signal can be used. A dither signal can be generated in either the digital or analogue domain and converted by either a DAC or ADC, as appropriate.

Analogue or digital calibration may be used to mitigate the effect of dither noise injection (for example if non-filtered dither is used).

Injection of dither after the quantizer and DWA can reduce/minimize the required power of the dither that is required to achieve de-correlation.

Embodiments of the invention can be used to process radio frequencies in the FM frequency range (for example 88MHz to 108MHz), the AM frequency band (27MHz), and/or a digital satellite radio range (25MHz). Also, embodiments of the invention can be used to process signals at base stations that may have a bandwidth of 40 - 80 MHz.

Further still applications of embodiments of the invention can include wideband sigma-delta converters that are used in medical or industrial situations, such as for providing ultrasound applications. Embodiments of the invention can be used for any multi-bit sigma-delta modulator for highly linear applications, including audio codecs.

## Claims

1. A sigma delta converter (1100) comprising:

an adder (1104);
a loop filter (1106);
a quantizer (1108);
a dynamic element matching component (1112);
a digital to analogue converter (1114);

wherein the adder (1104) is configured to add a converter input signal (1102) to an output signal from the digital to analogue converter (1114), the loop filter (1106) is configured to filter the output of the adder (1104), the quantizer (1108) is configured to process the output of the loop filter (1106), the output of the quantizer (1108) is configured as the output (1110) of the sigma delta converter and is also provided as an input to the dynamic element matching component (1112), and the output of the dynamic element matching component (1112) is provided as the input to the adder (1104);

wherein the sigma delta converter further comprises a dither signal generator (800) configured to provide a band limited dither signal (808; 1122);

wherein the band limited dither signal (808; 1122) is configured to be applied to a node in the sigma delta converter (1100).

**2.** The sigma delta converter of claim 1, wherein the dither signal generator (800) comprises:

a dither signal generator (802) configured to generate a dither signal (804); and
a filter (806) configured to remove one or more frequency components of the dither signal and provide a filtered dither signal (808) as the band limited dither signal.

**3.** The sigma delta converter (1100) of claim 2, wherein the one or more frequency components correspond to in-band frequencies associated with a use of the converter.

**4.** The sigma delta converter (1100) of claim 2 or claim 3, , wherein the filter (806) comprises one or more of a band pass filter, a band stop filter, a high-pass filter or a low-pass filter.

**5.** The sigma delta converter (1100) of any one of claims 2 to 4, wherein the filter (806) is an adjustable filter that is configured to receive a control signal indicative of an in-use frequency band, and adjust the frequency of the one or more frequency components that are removed in accordance with the control signal.

**6.** The sigma delta converter (1100) of any one of claims 2 to 5" wherein the dither signal is a pseudo random signal (804), optionally a digital signal with n bits.

**7.** The sigma delta converter (1100) of claim 6, further comprising a converter (810) configured to convert the filtered pseudo random signal (808) into a converted filtered pseudo random signal (812) having fewer bits than the filtered pseudo random signal (808).

**8.** The sigma delta converter (1100) of claim 7, wherein the converted filtered pseudo random signal (812) is a digital signal comprising one bit.

**9.** The sigma delta converter of any preceding claim, wherein the sigma delta converter further comprises a second adder (1120) located in the signal path between the loop filter (1106) and the quantizer (1108), wherein the second adder (1120) is configured to add the output of the loop filter (1106) and the band limited dither signal (1122) in order to generate the input signal for the quantizer (1108).

**10.** The sigma delta converter of any one of claims 1 or 3 to 8, wherein the sigma delta converter further comprises a second adder (1120') connected to the output of the quantizer (1108), wherein the second adder (1120') is configured to add the output of the quantizer (1108) to the band limited dither signal (1122) in order to generate the output signal (1110) of the sigma delta converter and the input signal for the dynamic element matching component (1112).

**11.** The sigma delta converter of any one of claims 1 or 3 to 8, wherein the sigma delta converter further comprises:

a second digital to analogue converter (1124) configured to convert the band limited dither signal (1122) to an analogue band limited dither signal, and provide the analogue band limited dither signal to the adder (1104) for adding to the converter input signal (1102) and the output of the digital to analogue converter (1114).

**12.** The sigma delta converter of any one of claims 1 or 3 to 8, wherein the sigma delta converter further comprises:

a third adder (1126) located in the signal path between the dynamic element matching component (1112) and the digital to analogue converter (1114), wherein the third adder (1126) is configured to add the band limited dither signal (1122) to the output of the dynamic element matching component (1112), and provide the resultant signal as the input to the digital to analogue converter (1114).

**13.** A dither signal generator (800) for a converter comprising:

a dither signal generator (802) configured to generate a dither signal (804); and
a filter (806) configured to remove one or more frequency components of the dither signal and provide a filtered dither signal (808) as a band limited dither signal.

**14.** A method of generating a band limited dither signal for a converter, comprising:

generating a dither signal (804);

removing one or more frequency components of the dither signal (804) in order to provide a filtered dither signal (808); and
providing the filtered dither signal as the band limited dither signal.

15. A computer program, which when run on a computer, causes the computer to configure the converter (1100) of any one of claims 1 to 12, the dither signal generator (800) of any one of claim 13, or perform the method of claim 14.

## Figure 1

## Figure 2

# Figure 3

conversion
cycle
304

No.

element
number
302

(a)    ■ 1    □ -1    (b)

306    308

# Figure 4

Output spectrum

## Figure 5

## Figure 7a

## Figure 7b

# Figure 6

(a)

(b)

(c)

(d)

Figure 8

800

Figure 9

902

Figure 10

Figure 11a

Figure 11b

Figure 11c

Figure 11d

## Figure 12a

## Figure 12b

## Figure 12c

## Figure 12d

Figure 12e

Figure 12f

## Figure 12g

## Figure 12h

Europäisches
Patentamt

European
Patent Office

Office européen
des brevets

**EUROPEAN SEARCH REPORT**

Application Number

EP 10 25 0817

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BAIRD R T ET AL: "LINEARITY ENHANCEMENT OF MULTIBIT DELTA SIGMA A/D AND CONVERTERS USING DATA WIGHTED AVERAGING" 1 December 1995 (1995-12-01), IEEE TRANSACTIONS ON CIRCUITS AND SYSTEMS II: EXPRESS BRIEFS, IEEE SERVICE CENTER, NEW YORK, NY, US LNKD- DOI:10.1109/82.476173, PAGE(S) 753 - 762 , XP000553740 ISSN: 1057-7130 * page 759, left-hand column, lines 13-17; figures 1,12 * | 1-12,15 | INV. H03M3/04 |
| X | US 2006/125668 A1 (MILLER KEVIN L [US] MILLER KEVIN LEE [US]) 15 June 2006 (2006-06-15) | 13,14 | |
| A | * page 5, right-hand column, lines 27-31; figures 1,6 * | 2,3 | |
| A | EP 0 515 154 A1 (AMERICAN TELEPHONE & TELEGRAPH [US] AT & T CORP [US]) 25 November 1992 (1992-11-25) * abstract * * column 3, lines 49-56; figure 2 * * column 1, lines 52-55 * * column 3, lines 49-51 * | 9,11,12 | TECHNICAL FIELDS SEARCHED (IPC) H03M |

The present search report has been drawn up for all claims

| Place of search | Date of completion of the search | Examiner |
|---|---|---|
| The Hague | 20 July 2010 | Galardi, Leonardo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................
& : member of the same patent family, corresponding document

EPO FORM 1503 03.82 (P04C01)

Europäisches
Patentamt

European
Patent Office

Office européen
des brevets

**Application Number**

EP 10 25 0817

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☒ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 10 25 0817

The Search Division considers that the present European patent application does not comply with the requirements of unity of invention and relates to several inventions or groups of inventions, namely:

    1. claims: 1-12, 15

        Multibit sigma delta converter with dither
                ---

    2. claims: 13, 14

        Dither signal generator
                ---

## ANNEX TO THE EUROPEAN SEARCH REPORT
## ON EUROPEAN PATENT APPLICATION NO.

EP 10 25 0817

This annex lists the patent family members relating to the patent documents cited in the above-mentioned European search report.
The members are as contained in the European Patent Office EDP file on
The European Patent Office is in no way liable for these particulars which are merely given for the purpose of information.

20-07-2010

| Patent document cited in search report | | Publication date | Patent family member(s) | | Publication date |
|---|---|---|---|---|---|
| US 2006125668 | A1 | 15-06-2006 | NONE | | |
| EP 0515154 | A1 | 25-11-1992 | DE | 69215271 D1 | 02-01-1997 |
| | | | DE | 69215271 T2 | 05-06-1997 |
| | | | DE | 69231317 D1 | 07-09-2000 |
| | | | DE | 69231317 T2 | 28-12-2000 |
| | | | HK | 42997 A | 11-04-1997 |
| | | | JP | 2061726 C | 10-06-1996 |
| | | | JP | 5160736 A | 25-06-1993 |
| | | | JP | 7093582 B | 09-10-1995 |
| | | | US | 5144308 A | 01-09-1992 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6384761 B, Melanson

**Non-patent literature cited in the description**

- **O. NYS ; R.K. HENDERSON.** Dynamic element matching techniques with arbitrary noise shaping function. *International symposium on circuit and system,* May 1996, 293-296